(19) Europäisches Patentamt
European Patent Office
Office européen des brevets

(11) **EP 4 113 139 B1**

(12) **EUROPEAN PATENT SPECIFICATION**

(45) Date of publication and mention of the grant of the patent:
**29.01.2025 Bulletin 2025/05**

(21) Application number: **22773375.5**

(22) Date of filing: **17.03.2022**

(51) International Patent Classification (IPC):
*G01R 31/367* (2019.01)

(52) Cooperative Patent Classification (CPC):
**G01R 31/367;** G01R 31/378; G01R 31/3842

(86) International application number:
**PCT/CN2022/081476**

(87) International publication number:
**WO 2022/213789 (13.10.2022 Gazette 2022/41)**

(54) **LITHIUM BATTERY SOC ESTIMATION METHOD AND COMPUTER-READABLE STORAGE MEDIUM**

VERFAHREN ZUR SCHÄTZUNG DES LADESTATUS EINER LITHIUMBATTERIE UND COMPUTERLESBARES SPEICHERMEDIUM

PROCÉDÉ D'ESTIMATION D'ÉTAT DE CHARGE DE BATTERIE AU LITHIUM, ET SUPPORT DE STOCKAGE LISIBLE PAR ORDINATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.10.2021   CN 202111215850**

(43) Date of publication of application:
**04.01.2023   Bulletin 2023/01**

(73) Proprietor: **SHENZHEN POWEROAK NEWENER CO., LTD**
**Shenzhen, Guangdong 518000 (CN)**

(72) Inventors:
• **MA, Hui**
**Shenzhen**
**Guangdong 518000 (CN)**

• **CANG, Wentao**
**Shenzhen**
**Guangdong 518000 (CN)**
• **LEI, Jianhua**
**Shenzhen**
**Guangdong 518000 (CN)**

(74) Representative: **Ipside**
**7-9 Allée Haussmann**
**33300 Bordeaux Cedex (FR)**

(56) References cited:
CN-A- 107 367 693      CN-A- 107 741 568
CN-A- 107 741 568      CN-A- 111 693 868
CN-A- 113 655 385      KR-A- 20170 020 072
US-A1- 2015 362 559    US-B2- 9 244 129

**Description**

## CROSS-REFERENCE TO RELATED APPLICATIONS

The present application claims priority to Chinese Patent Application No. 202111215850.X, filed with the Chinese Patent Office on October 19, 2021, titled "METHOD, DEVICE AND COMPUTER READABLE STORAGE MEDIUM FOR ESTIMATING SOC OF LITHIUM BATTERY"

## TECHNICAL FIELD

The present application relates to the technical field of SOC estimation of lithium batteries, and for example, relates to a method, device and computer readable storage medium for estimating SOC of a lithium battery.

## BACKGROUND OF THE INVENTION

With the development of lithium battery manufacturing and integration technology, advantages of lithium-ion batteries, such as a high energy density, a high unit voltage and a long cycle life, have been continuously excavated, and thus lithium-ion batteries have become the mainstream choice of new energy vehicles, energy storage power supplies and other systems. For energy storage power supplies, how to estimate the state of charge (SOC) of lithium batteries accurately and in real time is one of the core technologies of the energy storage power supplies. Accurate SOC estimation can avoid abnormal working modes such as over-charge and over-discharge of batteries, prolong the service life of batteries and reduce the incidence of safety accidents.

However, in the prior art, mapping relationships between battery voltage, current, temperature or the like and SOC are usually obtained by off-line training with machine learning algorithms, and then the measured data is substituted into the model to calculate the estimated SOC value. However, this method usually constructs a single global model, which is not conducive to representing the local process characteristics of SOC under multiple working conditions, and leads to insufficient accuracy and poor reliability of SOC estimation.

Relevant prior art is disclosed in CN 111 693 868 A, CN 107 367 693 B, US 2015/362559 A1, US 9 244 129 B2 and CN 107 741 568 A.

## SUMMARY OF THE INVENTION

A technical problem to be solved by the present application is to provide a method and a computer readable storage medium for estimating SOC of a lithium battery, so as to improve the accuracy and reliability of the estimated SOC value of the lithium battery.

To solve the above technical problem, a technical solution adopted by an embodiment of the present application is to provide a method for estimating SOC of a lithium battery as defined in independent claim 1, and the method comprises steps of:

collecting state data and corresponding SOC values of lithium batteries under different working conditions and establishing a sample set, and performing clustering analysis on the sample set to obtain a plurality of sample subsets; establishing a corresponding sub-model for each of the sample subsets to obtain sub-model functions of the plurality of sample subsets;
adding the state data of a sample to be tested respectively into the state data of each of the sample subsets, calculating a change value of the state data of each of the sample subsets before and after the adding operation, and selecting at least one sub-model close to the sample to be tested as the selected sub-model according to the change value; assigning a weight to the selected sub-model, and calculating the SOC value of the sample to be tested.

Preferably, the state data of the lithium battery comprises at least one of charging and discharging current, terminal voltage and temperature of the lithium battery.

Preferably, the step of performing clustering analysis on the sample set to obtain a plurality of sample subsets comprises:
performing clustering analysis on the sample set to obtain a plurality of sample subsets by using the K-means algorithm, which comprises steps of:

initializing the number N of sample subsets and the maximum iteration number $N_{inter}$;
randomly selecting the state data of N samples from the sample set as centers $\mu_1, \mu_2,...,\mu_j,...,\mu_N$ of N sample subsets $(X_1,Y_1), (X_2,Y_2),...,(X_j,Y_j),...,(X_N,Y_N)$, wherein X represents the state data, Y represents the SOC value, and $\mu$

represents the cluster center, $1 \le j \le N$;

setting $k = 1, 2, ..., N_{inter}$;

initializing each of the N sample subsets $(X_1, Y_1), (X_2, Y_2), ..., (X_j, Y_j), ..., (X_N, Y_N)$ into an empty set $(X_j, Y_j) = \varphi$, $j = 1, 2, ..., N$;

calculating the distance between the state data $x_i$ of each sample $(x_i, y_i)$ and each cluster center $\mu_j$, wherein $x_i$ represents the state data of a certain sample and $y_i$ represents the SOC value of a certain sample; and the formula for calculation is as follows:

$$d_{i,j} = \left\| x_i - \mu_j \right\|_2^2 \; ;$$

putting the sample $(x_i, y_i)$ into the sample subset $(X_j, Y_j)$ corresponding to the smallest $d_{i,j}$, and updating the sample subset $(X_j, Y_j) = (X_j, Y_j) \cup (x_i, y_i)$;

$$\mu_j = \frac{1}{\left| X_j \right|} \sum_{x \in X_j} x$$

calculating the cluster center                of each updated sample subset, wherein $|X_j|$ is the number of samples of the jth sample subset;

$$\sum_{j=1}^{N} | \mu_j(k) - \mu_j(k-1) | \le 0.01$$

if                , then outputting sample subsets $(X_1, Y_1)$, $(X_2, Y_2), ..., (X_j, Y_j), ..., (X_N, Y_N)$, wherein $k = 1, 2, ..., N_{inter}$;

otherwise, making $k \leftarrow k+1$ until the iteration number reaches the maximum iteration number $N_{inter}$.

Preferably, the step of establishing a corresponding sub-model for each of the sample subsets to obtain sub-model functions of the plurality of sample subsets comprises:

establishing a corresponding PLS sub-model for each of the sample subsets by using a partial least squares regression method to obtain PLS sub-model functions of the plurality of sample subsets;

the PLS sub-model is expressed as follows:

$$\begin{cases} X_j = T_j P_j^T + E_{X_j} \\ Y_j = U_j Q_j^T + E_{Y_j} \end{cases}$$

wherein $T_j$ and $U_j$ are the score matrices of the jth PLS sub-model, $P_j$ and $Q_j$ are the load matrices of the jth PLS sub-model, and $E_{X_j}$ and $E_{Y_j}$ are the residual matrices of the jth PLS sub-model;

the score matrices are linked by linear regression:

$$U_j = T_j B_j + E_j$$

wherein $B_j$ and $E_j$ are the diagonal matrix and regression residual matrix of the jth PLS sub-model respectively;

the PLS sub-model functions of the plurality of sample subsets are expressed as follows:

$$\begin{cases} f_1 = T_1 B_1 Q_1^T \\ \quad\vdots \\ f_j = T_j B_j Q_j^T \\ \quad\vdots \\ f_N = T_N B_N Q_N^T \end{cases}$$

wherein f represents the sub-model function.

Preferably, the operation of adding the state data of a sample to be tested respectively into the state data of each of the sample subsets and calculating a change value of the state data of each of the sample subsets before and after the adding operation comprises:

adding the state data $x_{test}$ of the sample to be tested respectively into the state data $x_1,...,x_j,..., x_N$ of each of the sample subsets to obtain new state data $(X_1, x_{test}),..., (X_j, x_{test}),..., (X_N, x_{test})$;
calculating a first divergence information value $K_j$ between $X_j$ and $(X_j, x_{test})$, wherein the formula of the first divergence information value $K_j$ is as follows:

$$K_j = K[X_j \| (X_j, x_{test})]$$
$$= \frac{1}{2} trace\left\{ (\Sigma_1 - \Sigma_2)(\Sigma_2^{-1} - \Sigma_1^{-1}) \right\} + \frac{1}{2} trace\left\{ (\Sigma_1^{-1} + \Sigma_2^{-1})(\sigma_1 - \sigma_2)(\sigma_1 - \sigma_2)^T \right\}$$

wherein $\Sigma_1$ and $\sigma_1$ are respectively the covariance matrix and mean of $X_j$, $\Sigma_2$ and $\sigma_2$ are respectively the covariance matrix and mean of $(X_j, x_{test})$, and trace is the matrix tracing operator;
performing normalization processing on the first divergence information value $K_j$ to obtain a second divergence information value $K_j'$, wherein the formula for normalization is as follows:

$$K_j' = 1 - \frac{K_j - \min(K_1, K_2, \cdots K_N)}{\max(K_1, K_2, \cdots K_N) - \min(K_1, K_2, \cdots K_N)} \in [0,1] \quad .$$

Preferably, the step of selecting at least one sub-model close to the sample to be tested as the selected sub-model according to the change value comprises:

comparing $K_j'$ with a preset divergence information value $\varepsilon$, and taking the sub-model which corresponds to $K_j'$ not less than the preset divergence information value $\varepsilon$ as the selected sub-model close to the sample to be tested, and the expression formula of a set of the selected sub-models is as follows:

$$Q_c = \left\{ q_1, q_2, \cdots, q_{N_c} \right\}, \quad Q_c = \left\{ j \mid K_j' \geq \varepsilon \right\},$$

wherein $N_c$ is the total number of the selected sub-models.

As defined in independent claim 1, the step of assigning a weight to the selected sub-model comprises:

making the weight of each selected sub-model in the selected sub-models be $P(X_s|x_{test})$, $s = q_1,q_2,...,q_{N_c}$; the expression formula of the weight is as follows:

$$P(X_s \mid x_{test}) = \frac{P(X_s)P(x_{test} \mid X_s)}{\sum\limits_{s=q_1}^{q_{N_c}} P(X_s)P(x_{test} \mid X_s)} \ ;$$

wherein

$$P(x_{test} \mid X_s) = \frac{K_s^{'}}{\sum\limits_{s=q_1}^{q_{N_c}} K_s^{'}}$$

$$P(X_s) = \frac{1}{N_c} .$$

Preferably, the step of calculating the SOC value of the sample to be tested is to calculate the SOC value through the following formula:

$$\hat{y}_{test} = \sum_{s=q_1}^{q_{N_c}} P(X_s \mid x_{test})f_s(x_{test}) = \frac{\sum\limits_{s=q_1}^{q_{N_c}} K_s^{'}f_s(x_{test})}{\sum\limits_{s=q_1}^{q_{N_c}} K_s^{'}} .$$

To solve the above technical problem, another technical solution adopted by an embodiment of the present application, which is not encompassed by the wording of the claims but is considered as useful for understanding the invention, is to provide a device for estimating SOC of a lithium battery, and the device comprises:

an acquisition module, being configured to collect state data and corresponding SOC values of lithium batteries under different working conditions and establish a sample set, and perform clustering analysis on the sample set to obtain a plurality of sample subsets;
a model establishing module, be configured to establish a corresponding sub-model for each of the sample subsets to obtain sub-model functions of the plurality of sample subsets;
a selection module, being configured to add the state data of a sample to be tested respectively into the state data of each of the sample subsets, calculate a change value of the state data of each of the sample subsets before and after the adding operation, and select at least one sub-model close to the sample to be tested as the selected sub-model according to the change value;
an SOC calculating module, being configured to assign a weight to the selected sub-model, and calculate the SOC value of the sample to be tested.

To solve the above technical problem, yet another technical solution adopted by an embodiment of the present application is to provide a computer readable storage medium having computer executable instructions stored therein, and the computer executable instructions enable a computer to execute the method described above.
To solve the above technical problem, which is not encompassed by the wording of the claims but is considered as useful for understanding the invention, yet another technical solution adopted by an embodiment of the present application is to provide an electronic equipment which comprises:

at least one processor; and
a memory communicatively connected with the at least one processor; wherein
the memory stores instructions executable by the at least one processor, and the instructions are executed by the at least one processor to enable the at least one processor to execute the method as described above.

To solve the above technical problem, yet another technical solution adopted by an embodiment of the present application is to provide a computer program product comprising a computer program stored on a nonvolatile computer readable storage medium, the computer program comprises program instructions which, when executed by an electronic equipment, enable the electronic equipment to execute the method as described above.

Embodiments of the present application provide a method and a computer readable storage medium for estimating SOC of a lithium battery. For the method, device and computer readable storage medium for estimating SOC of the lithium battery, state data and corresponding SOC values of lithium batteries under different working conditions are collected to establish a sample set, and clustering analysis is performed on the sample set to obtain a plurality of sample subsets; then a corresponding sub-model is established for each of the sample subsets to obtain sub-model functions of the plurality of sample subsets. Piecewise approximate linearization is performed on the nonlinear lithium battery system by clustering analysis to obtain a multi-segment local linear sub-model, thereby avoiding the defect of low generalization performance of a single global model. The state data of a sample to be tested is respectively added into the state data of each of the sample subsets to calculate a change value of the state data of each of the sample subsets before and after the adding operation, and at least one sub-model close to the sample to be tested is selected as the selected sub-model according to the change value; and finally, a weight is assigned to the selected sub-model to calculate the SOC value of the sample to be tested. The relevant sub-models are selected from the perspective of probability density distribution of samples, the difference of probability density distribution among sample sets is taken into full consideration to accordingly assign weights to the relevant sub-models, and the final SOC estimation is output so that the SOC estimation result has higher accuracy and reliability.

## BRIEF DESCRIPTION OF THE DRAWINGS

One or more embodiments are illustrated by corresponding attached drawings, and this does not constitute limitation of the embodiments. Element labeled with the same reference numerals in the attached drawings represent similar elements, and unless otherwise stated, figures in the attached drawings do not constitute scale limitation.

FIG. 1 is a flowchart diagram of a method for estimating SOC of a lithium battery provided according to an embodiment of the present application.
FIG. 2 is a diagram illustrating an estimation result of a method for estimating SOC of a lithium battery provided according to an embodiment of the present application.
FIG. 3 is a structural block diagram of a device for estimating SOC of a lithium battery provided according to an embodiment of the present application.
FIG. 4 is a schematic view illustrating the hardware structure of an electronic equipment adapted to a method for estimating SOC of a lithium battery provided according to an embodiment of the present application.

## DETAILED DESCRIPTION OF EMBODIMENTS

In order to make objectives, technical solutions and advantages of the present application clearer, the present application will be further described in detail hereinafter with reference to attached drawings and embodiments. It shall be appreciated that, the specific embodiments described herein are only used to explain the present application, and are not used to limit the present application.

It shall be noted that, all features in the embodiments of the present application may be combined with each other without conflict as long as all the combinations are within the scope claimed in the present application. In addition, although functional module division is made in the schematic diagrams of the device and logical sequences are shown in the flowchart diagrams, in some cases, the steps shown or described can be executed with module division or sequences different from those in the schematic diagrams of the device and the flowchart diagrams.

Unless otherwise defined, all technical and scientific terms used in this specification have the same meanings as commonly understood by those skilled in the art of the present application. The terms used in the specification of the present application are only for the purpose of describing specific embodiments, and are not intended to limit the present application. The term "and/or" used in this specification comprises any and all combinations of one or more associated items listed.

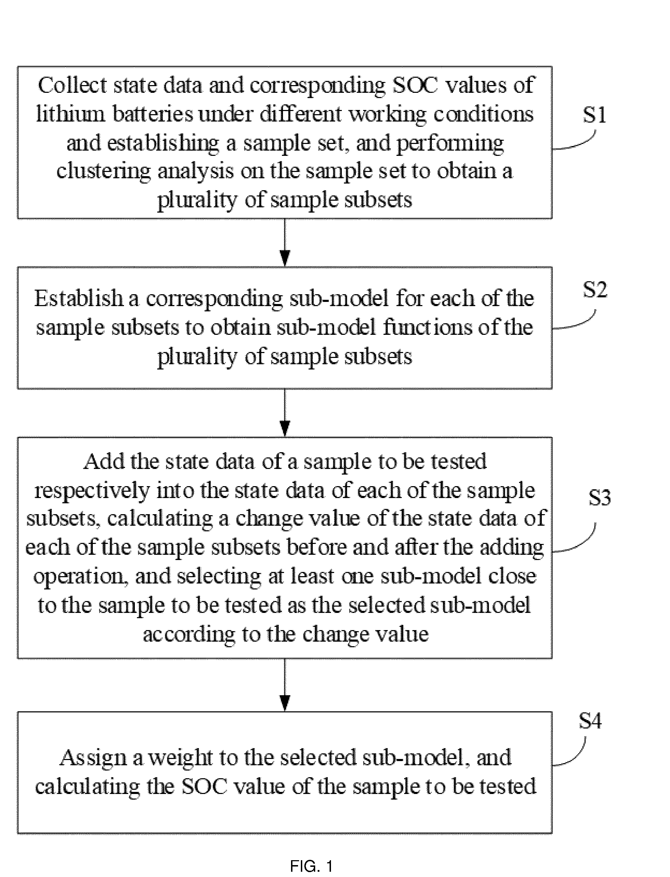

Please refer to FIG. 1, which is a flowchart diagram of a method for estimating SOC of a lithium battery provided according to an embodiment of the present application. As shown in FIG. 1, steps of the method comprise:
S1: collecting state data and corresponding SOC values of lithium batteries under different working conditions and establishing a sample set, and performing clustering analysis on the sample set to obtain a plurality of sample subsets.

The sample subsets comprise $(X_1,Y_1)$, $(X_2,Y_2)$,...,$(X_j,Y_j)$,...,$(X_N,Y_N)$, wherein $1 \leq j \leq N$, N represents the total number of sample subsets, X represents the state data of the sample subsets, and Y represents the SOC value of the sample subsets. $(X_1,Y_1)$, $(X_2,Y_2)$,...,$(X_j,Y_j)$,...,$(X_N,Y_N)$ are respectively sets of a plurality of samples, i.e., $(X_1,Y_1)$= { $(x_{11},y_{11})$, $(x_{12},y_{12})$,..., $(x_{1a},y_{1a})$}, $(X_2,Y_2)$= { $(x_{21},y_{21})$, $(x_{22},y_{22})$,..., $(x_{2b},y_{2b})$}},..., $(X_j,Y_j)$ ={ $(x_{j1},y_{j1})$, $(x_{j2},y_{j2})$,..., $(x_{jc},y_{jc})$},..., $(X_N,Y_N)$= { $(x_{N1},y_{N1})$, $(x_{N2},y_{N2})$,..., $(x_{Nn},y_{Nn})$}. X represents the state data of a certain sample, y represents the SOC value of a certain sample, $A = a + b + c... + n$, and A represents the total number of samples in the sample set.

Specifically, the state data comprises at least one of charging and discharging current, terminal voltage and temperature of the lithium battery, and the expression formula of state data x of a certain sample is x=[I,U,T], wherein I, U, and T are respectively sampling values of charging and discharging current, terminal voltage and temperature of the lithium battery.

The SOC value refers to the ratio of the remaining capacity of the lithium battery to the capacity of the lithium battery in a fully charged state, and the SOC value ranges from 0% to 100%. When the SOC value is equal to 0%, it means that the lithium battery is fully discharged, and when the SOC value is 100%, it means that the lithium battery is fully charged. By knowing the SOC value, the operation of the lithium battery can be controlled.

Under each working condition, each group of state data x corresponds to an SOC value y, the state data x is an independent variable, and the corresponding SOC value y is a dependent variable. The independent variable x is taken as an input model and the dependent variable y is taken as an output model, and the relationship between the independent variable x and the dependent variable y is calculated to acquire an SOC estimation model of the lithium battery.

The sample sets collected during the above steps are all used as training sets to obtain the SOC estimation model. In the specific application process, in order to test the accuracy of the established SOC estimation model, the sample sets under different working conditions may be divided into training sets and test sets. For example, 75% of the sample sets are used as training sets $D_{train}$={$X_{train}$,$Y_{train}$} and the other 25% are used as test sets $D_{test}$={$X_{test}$,$Y_{test}$}.

Specifically, the clustering analysis is used for performing piecewise analysis on the nonlinear lithium battery system for approximate linearization.

Specifically, the clustering analysis may adopt any clustering analysis algorithm currently available. In one implementation, the K-means clustering algorithm is used to perform clustering analysis on the sample set, and the specific steps are as follows:

S11: initializing the number N of sample subsets and the maximum iteration number $N_{inter}$;
S12: randomly selecting the state data of N samples from the sample set as initial cluster centers $\mu_1$, $\mu_2$,...,$\mu_j$,...,$\mu_N$ of N sample subsets $(X_1,Y_1)$, $(X_2,Y_2)$,...,$(X_j,Y_j)$,...,$(X_N,Y_N)$, wherein $\mu$ represents the cluster center, $1 \leq j \leq N$;
S13: setting k = 1, 2,...,$N_{inter}$;

(a) initializing each of the N sample subsets $(X_1,Y_1)$, $(X_2,Y_2)$,...,$(X_j,Y_j)$,...,$(X_N,Y_N)$ into an empty set $(X_j,Y_j)$=$\varphi$, j=1,2,...,N;
(b) calculating the distance between the state data $x_i$ of each sample $(x_i,y_i)$ and each cluster center $\mu_j$, wherein $x_i$ represents the state data of a certain sample and $y_i$ represents the SOC value of a certain sample; and the formula for calculation is as follows:

$$d_{i,j} = \left\| x_i - \mu_j \right\|_2^2 ;$$

(c) putting the sample $(x_i,y_i)$ into the sample subset $(X_j,Y_j)$ corresponding to the smallest $d_{i,j}$, and updating the sample subset $(X_j,Y_j)$ =$(X_j,Y_j)$ $\cup$ $(x_i,y_i)$;

$$\mu_j = \frac{1}{\left| X_j \right|} \sum_{x \in X_j} x$$

(d) calculating the cluster center of each updated sample subset, wherein $|X_j|$ is the number of samples of the jth sample subset;

$$\sum_{j=1}^{N} |\mu_j(k) - \mu_j(k-1)| \le 0.01$$

(e) if $\qquad$, then outputting sample subsets $(X_1, Y_1)$, $(X_2, Y_2),...,(X_j, Y_j),...,(X_N, Y_N)$, wherein $k=1,2,...,N_{inter}$;

(f) otherwise, making $k \leftarrow k+1$ until the iteration number reaches the maximum iteration number $N_{inter}$.

S2: establishing a corresponding sub-model for each of the sample subsets to obtain sub-model functions of the plurality of sample subsets.

Linear regression operation is performed on the sample subsets $(X_1, Y_1)$, $(X_2, Y_2),...,(X_j, Y_j),...,(X_N, Y_N)$ after the clustering analysis in the step S1 to acquire a regression classification model for SOC of the lithium battery.

Preferably, partial least squares (PLS) regression method is used to establish a corresponding PLS sub-model for each sample subset so as to obtain PLS sub-model functions of the plurality of sample subsets. PLS is a kind of statistical method which mainly uses the characteristics of principal component analysis to respectively project predicted variables and observed variables into a new space so as to find one linear regression model.

The PLS sub-model is expressed as follows:

$$\begin{cases} X_j = T_j P_j^T + E_{X_j} \\ Y_j = U_j Q_j^T + E_{Y_j} \end{cases};$$

wherein $T_j$ and $U_j$ are the score matrices of the jth PLS sub-model, $P_j$ and $Q_j$ are the load matrices of the jth PLS sub-model, and $E_{Xj}$ and $E_{Yj}$ are the residual matrices of the jth PLS sub-model;

The score matrices $T_j$ and $U_j$ represent the relationship between each index variable and the extracted common factor. If the score on a certain common factor is high, then it indicates that the relationship between the index variable and the common factor is closer. The load matrices $P_j$ and $Q_j$ refer to the coefficients of the factor expressions of various original variables, which mainly represent the degree of influence of the extracted common factor on the original variables. The residual matrices $E_{Xj}$ and $E_{Yj}$ refer to subtracting the estimated value of a sample from the observed value of the sample.

The score matrices are linked by linear regression:

$$U_j = T_j B_j + E_j$$

wherein $B_j$ and $E_j$ are respectively the diagonal matrix and regression residual matrix of the jth PLS sub-model. The diagonal matrix refers to a matrix in which all elements other than the main diagonal are 0.

Finally, the PLS sub-model functions of the plurality of sample subsets are expressed as follows:

$$\begin{cases} f_1 = T_1 B_1 Q_1^T \\ \vdots \\ f_j = T_j B_j Q_j^T \\ \vdots \\ f_N = T_N B_N Q_N^T \end{cases}.$$

Preferably, principal component regression (PCR) is used to establish a corresponding PCR sub-model for each sample subset so as to obtain PCR sub-model functions of the plurality of sample subsets. The PCR sub-model is expressed as follows:

$$\begin{cases} g_1 = \beta_{1,1}t_{1,1} + \beta_{2,1}t_{2,1} + \ldots + \beta_{h,1}t_{h,1} \\ \vdots \\ g_j = \beta_{1,j}t_{1,j} + \beta_{2,j}t_{2,j} + \ldots + \beta_{h,j}t_{h,j} \\ \vdots \\ g_N = \beta_{1,N}t_{1,N} + \beta_{2,N}t_{2,N} + \ldots + \beta_{h,N}t_{h,N} \end{cases}$$

Specifically, according to the jth sample subset $(X_j, Y_j)$, after the sample matrix $X_j$ is standardized, the covariance matrix $\Sigma_j$ thereof may be expressed as follows:

$$\Sigma_j = \frac{X_j^T X_j}{n-1}$$

spectral decomposition is performed thereon:

$\Sigma_j P_{i,j} = \lambda_{i,j} P_{i,j}$, i=1,2,3,...h;

wherein h is the number of principal components, $P_{i,j}$ is the eigenvector of the covariance matrix, and $\lambda_{i,j}$ are eigenvalues sorted in the descending order. Representative principal components are extracted to explain most of the changes in the original data:

$$X_j = t_{1,j}p_{1,j}^T + t_{2,j}p_{2,j}^T + \ldots + t_{h,j}p_{h,j}^T + E_{h,j}$$

wherein $t_{i,j} = X_j P_{i,j}$ is the principal component vector. Finally, the PCR sub-model functions of the plurality of sample subsets are expressed as follows:

$$\begin{cases} g_1 = \beta_{1,1}t_{1,1} + \beta_{2,1}t_{2,1} + \ldots + \beta_{h,1}t_{h,1} \\ \vdots \\ g_j = \beta_{1,j}t_{1,j} + \beta_{2,j}t_{2,j} + \ldots + \beta_{h,j}t_{h,j} \\ \vdots \\ g_N = \beta_{1,N}t_{1,N} + \beta_{2,N}t_{2,N} + \ldots + \beta_{h,N}t_{h,N} \end{cases}$$

wherein $\beta_{i,j}$ is the regression coefficient, and N is the number of sample subsets.

S3: adding the state data of a sample to be tested respectively into the state data of each of the sample subsets, calculating a change value of the state data of each of the sample subsets before and after the adding operation, and selecting at least one sub-model close to the sample to be tested as the selected sub-model according to the change value.

The step of calculating a change value of the state data of each of the sample subsets before and after the adding operation may be performed by KL divergence $K_j^{'}$ , which measures the difference of probability density distribution before and after the change of state data.

Specifically, the data state $x_{test}$ of the sample to be tested is acquired, and the data state $x_{test}$ of the sample to be tested is added to the state data $x_1,...,x_j,..., x_N$ of each of the sample subsets to obtain new state data $(X_1, x_{test}),...., (X_j, x_{test}),...., (X_N, x_{test})$, and a first divergence information value $K_j$ (KL divergence) between $X_j$ and $(X_j, x_{test})$ is calculated,

wherein the formula of the first divergence information value $K_j$ is as follows:

$$K_j = K[X_j \| (X_j, x_{test})]$$

$$= \frac{1}{2} trace\left\{(\Sigma_1 - \Sigma_2)(\Sigma_2^{-1} - \Sigma_1^{-1})\right\} + \frac{1}{2} trace\left\{(\Sigma_1^{-1} + \Sigma_2^{-1})(\sigma_1 - \sigma_2)(\sigma_1 - \sigma_2)^T\right\}$$

wherein $\Sigma_1$ and $\sigma_1$ are respectively the covariance matrix and mean of $X_j$, $\Sigma_2$ and $\sigma_2$ are respectively the covariance matrix and mean of $(X_j, x_{test})$, and trace is the matrix tracing operator.

Normalization processing is performed on the first divergence information value $K_j$ to acquire a second divergence information value $K_j^{'}$, wherein the formula for normalization is as follows:

$$K_j^{'} = 1 - \frac{K_j - \min(K_1, K_2, \cdots K_N)}{\max(K_1, K_2, \cdots K_N) - \min(K_1, K_2, \cdots K_N)} \in [0, 1]$$

,

a larger $K_j^{'}$ represents a higher similarity between $x_{test}$ and $Xj$, i.e., $x_{test}$ being closer to the working conditions of lithium batteries characterized by $X_j$. Therefore, $N_c$ sub-models corresponding to the larger $K_j^{'}$ are selected from the sample probability density distribution.

Specifically, the second divergence information value $K_j^{'}$ is compared with a preset divergence information value ε, and the sub-model which corresponds to $K_j^{'}$ not less than the preset divergence information value ε is taken as the selected sub-model close to the sample to be tested. The expression formula of a set of the selected sub-models is as follows: $Q_c = \{q_1, q_2, \cdots q_{N_c}\}$, $Q_c$ is determined by the following formula: $Q_c = \left\{ j \mid K_j^{'} \geq \varepsilon \right\}$, wherein $N_c$ is the total number of the selected sub-models.

S4: assigning a weight to the selected sub-model, and calculating the SOC value of the sample to be tested.

The weight of each selected sub-model is related to the second divergence information value $K_j^{'}$, and the weight of each selected sub-model in the selected sub-models is made to be , s=$q_1$,$q_2$,..., $q_{Nc}$;

according to Bayes' total probability formula, the weight thereof may be further expressed as follows:

$$P(X_s \mid x_{test}) = \frac{P(X_s)P(x_{test} \mid X_s)}{\sum_{s=q_1}^{q_{N_c}} P(X_s)P(x_{test} \mid X_s)}$$

wherein

$$P(x_{test} \mid X_s) = \frac{K_s^{'}}{\sum_{s=q_1}^{q_{N_c}} K_s^{'}},$$

wherein $P(X_s \mid x_{test})$ is the posterior probability that the test sample $x_{test}$ belongs to $X_s$, $P(X_s)$ is the prior probability that $X_s$ can describe the current working condition of the lithium battery, and $P(x_{test} \mid X_s)$ represents the probability that $x_{test}$ may be generated by $X_s$.

It is assumed that the probability of each sub-model being selected for integration is equal, then:

$$P(X_s) = \frac{1}{N_c}.$$

The output result of SOC integration estimation corresponding to the test sample $x_{test}$ is obtained according to the weight assigned to each selected sub-model and in combination with the sub-model function thereof.

Preferably, when partial least squares (PLS) regression method is used to establish a corresponding PLS sub-model for each sample subset, the output result of SOC integration estimation corresponding to the test sample $x_{test}$ is as follows:

$$\hat{y}_{test} = \sum_{s=q_1}^{q_{N_c}} P(X_s \mid x_{test}) f_s(x_{test}) = \frac{\sum_{s=q_1}^{q_{N_c}} K_s^{'} f_s(x_{test})}{\sum_{s=q_1}^{q_{N_c}} K_s^{'}}.$$

When principal component regression (PCR) is used to establish a corresponding PCR sub-model for each sample subset, the output result of SOC integration estimation corresponding to the test sample $x_{test}$ is as follows:

$$\hat{y}_{test} = \sum_{s=q_1}^{q_{N_c}} P(X_s \mid x_{test}) g_s(x_{test}) = \frac{\sum_{s=q_1}^{q_{N_c}} K_s^{'} g_s(x_{test})}{\sum_{s=q_1}^{q_{N_c}} K_s^{'}}.$$

In some embodiments, the method for estimating SOC of the lithium battery further comprises verifying the SOC estimation model of the lithium battery after acquiring the SOC estimation model. After acquiring the SOC estimation model of the lithium battery, the SOC value obtained by the SOC estimation model of the lithium battery may be verified by root mean square error and average relative error, so as to determine whether the SOC value obtained by the SOC estimation model of the lithium battery is accurate or not.

Specifically, the formula of the error term is:

$$RMSE = \sqrt{\frac{1}{l} \sum_{p=1}^{l} (y_{test} - \hat{y}_{test})^2}$$

$$ARE = \frac{1}{l}\sum_{p=1}^{l}\frac{\left| y_{test} - \hat{y}_{test} \right|}{y_{test}} \times 100\%$$

wherein I is the number of test samples, $y_{test}$ is the true value of SOC, and $\hat{y}_{test}$ is the estimated value of SOC.

The verification results of the SOC estimation model of the lithium battery are shown in the following table.

| Error items | RMSE | ARE/% |
|---|---|---|
| Results | 0.767 | 2.63 |

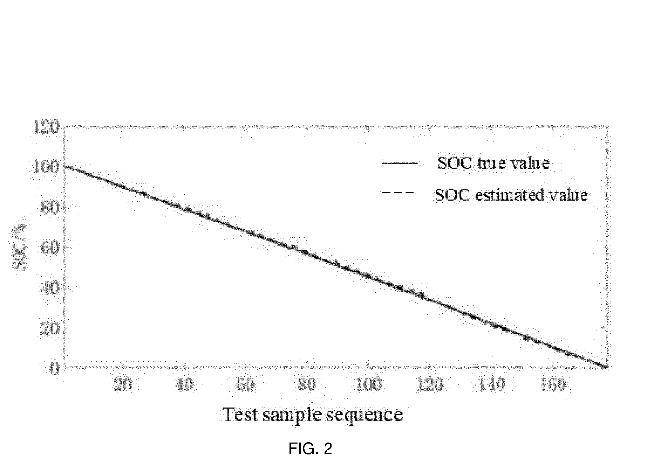

Please refer to FIG. 2, which is a diagram illustrating an estimation result of a method for estimating SOC of a lithium battery provided according to an embodiment of the present application. The straight line represents the true value of SOC of the lithium battery, and the dotted line represents the estimated value obtained according to the SOC estimation model of the lithium battery. As shown in FIG. 2, the true value of SOC of the lithium battery and the estimated value of SOC of the lithium battery are approximately on the same straight line.

In actual measurement, at least one of the terminal voltage, charging and discharging current and temperature of the lithium battery is acquired in real time, and input into the SOC estimation model of the lithium battery, so as to acquire the corresponding SOC values of the lithium battery corresponding to the terminal voltage, charging and discharging current and temperature.

Different from the situation of related technologies, the embodiments of the present application provide a method for estimating SOC of a lithium battery, in the method for estimating SOC of the lithium battery, state data and corresponding SOC values of lithium batteries under different working conditions are collected to establish a sample set, and clustering analysis is performed on the sample set to obtain a plurality of sample subsets; then a corresponding sub-model is established for each of the sample subsets to obtain sub-model functions of the plurality of sample subsets; next, the state data of a sample to be tested is respectively added into the state data of each of the sample subsets to calculate a change value of the state data of each of the sample subsets before and after the adding operation, and at least one sub-model close to the sample to be tested is selected as the selected sub-model according to the change value; and finally, a weight is assigned to the selected sub-model to calculate the SOC value of the sample to be tested. By obtaining the estimated SOC value of the lithium battery in the aforementioned manner, the accuracy and reliability of the estimated SOC value of the lithium battery are improved.

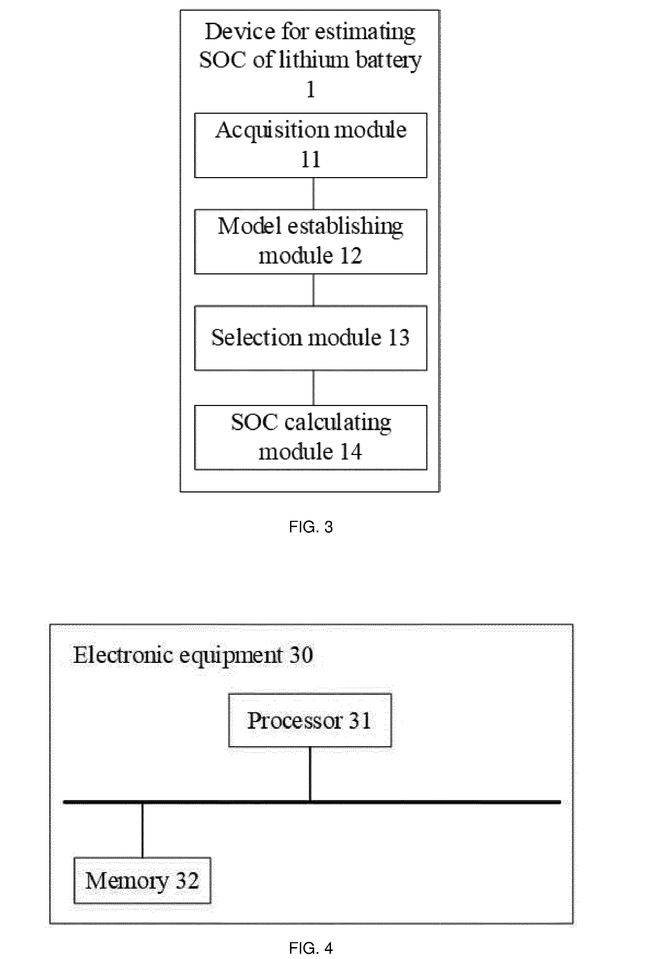

Please refer to FIG. 3, which is a structural block diagram of a device for estimating SOC of a lithium battery provided according to an embodiment of the present application. As shown in FIG. 3, the device 1 for estimating SOC of the lithium battery comprises an acquisition module 11, a model establishing module 12, a selection module 13 and an SOC calculating module 14.

The acquisition module 11 is configured to collect state data and corresponding SOC values of lithium batteries under different working conditions and establish a sample set, and perform clustering analysis on the sample set to obtain a plurality of sample subsets.

The model establishing module 12 is configured to establish a corresponding sub-model for each of the sample subsets to obtain sub-model functions of the plurality of sample subsets.

The selection module 13 is configured to add the state data of a sample to be tested respectively into the state data of each of the sample subsets, calculate a change value of the state data of each of the sample subsets before and after the adding operation, and select at least one sub-model close to the sample to be tested as the selected sub-model according to the change value.

The SOC calculating module 14 is configured to assign a weight to the selected sub-model, and calculate the SOC value of the sample to be tested.

It shall be noted that the device for estimating SOC of the lithium battery described above can execute the method for estimating SOC of the lithium battery provided according to the embodiment of the present application, and has corresponding functional modules and beneficial effects for executing the method. For the technical details not described in detail in the embodiment of the device for estimating SOC of the lithium battery, please refer to the method for estimating SOC of the lithium battery provided according to the embodiment of the present application.

The embodiments of the device described above are only for illustrative purpose. The units illustrated as separate components may be or may not be physically separated, and components displayed as units may be or may not be physical units. That is, these units and components may be located in one place or distributed over multiple network units. Some or all of the modules may be selected according to actual needs to achieve the purpose of the solution of the embodiments.

Referring to FIG. 4, an embodiment of the present application provides an electronic equipment 30, which comprises: at least one processor 31, one processor 31 being taken as an example in FIG. 4; and a memory 32 communicatively connected to the at least one processor 31, connection through a bus being taken as an example in FIG. 4.

The memory 32 stores instructions that can be executed by the at least one processor 31, and the instructions are executed by the at least one processor 31 to enable the at least one processor 31 to execute the method for estimating SOC of the lithium battery described above.

As a nonvolatile computer readable storage medium, the memory 32 may be used to store nonvolatile software programs, nonvolatile computer executable programs and modules, such as program instructions/modules corresponding to the method for estimating SOC of the lithium battery in the embodiments of the present application. The processor 31 runs the nonvolatile software programs, instructions and modules stored in the memory 32, thereby executing various functional applications and data processing of the electronic equipment 30, i.e., implementing the method for estimating SOC of the lithium battery provided by the embodiments of the method described above.

The memory 32 may comprise a program storage area and a data storage area, wherein the program storage area may store operating systems and application programs required by at least one function. In addition, the memory 32 may comprise a high-speed random access memory, and may also comprise a nonvolatile memory. For example, the memory 32 comprises at least one magnetic disk memory device, flash memory device, or other nonvolatile solid-state memory device. In some embodiments, the memory 32 optionally comprises memories remotely provided relative to the processor 31.

The one or more modules are stored in the memory 32, and when executed by the one or more processors 31, the one or more modules execute the method for estimating SOC of the lithium battery in any of the embodiments of the method described above, e.g., execute the steps of the method of FIG. 1 described above.

The electronic equipment described above may execute the method provided according to the embodiments of the present application, and have corresponding functional modules for executing the method. For technical details not described in detail in this embodiment, please refer to the method provided according to the embodiments of the present application.

The electronic equipment of the embodiment of the present application exists in various forms, including but not limited to:

(1) an ultra-mobile personal computer equipment: this kind of equipment belongs to the category of personal computers, which have the functions of calculating and processing, and generally also have the characteristics of mobile Internet access. Such terminals comprise PDA, MID and UMPC equipments, such as iPad.

(2) a server: it is an equipment that provides computing services, and the components of the server comprise processor, hard disk, memory, system bus or the like. The architecture of the server is similar to that of a general computer, but due to the need of providing highly reliable services, it requires higher processing power, stability, reliability, security, scalability, manageability or the like.

(3) Other electronic devices with data interaction function.

An embodiment of the present application further provides a computer readable storage medium, in which computer executable instructions are stored. The computer executable instructions are executed by one or more processors to for example execute the steps of the method of FIG. 1 described above and implement the functions of the modules in FIG. 3.

An embodiment of the present invention provides a computer program product, which comprises a computer program stored on a nonvolatile computer readable storage medium. The computer program comprises program instructions which, when executed by the electronic equipment, enable the electronic equipment to execute the method for estimating SOC of the lithium battery in any of the embodiments of the method described above, e.g., execute the steps S1 to S4 of the method of FIG. 1 described above and implement the function of modules 11 to 14 in FIG. 3.

The embodiments of the device described above are only for illustrative purpose. The units illustrated as separate components may be or may not be physically separated, and components displayed as units may be or may not be physical units. That is, these units and components may be located in one place or distributed over multiple network units. Some or all of the modules may be selected according to actual needs to achieve the purpose of the solution of the embodiments.

From the description of the above embodiments, those of ordinary skill in the art may clearly appreciate that each embodiment may be realized by means of software plus a general hardware platform, and of course, it may also be realized by hardware. As shall be appreciated by those of ordinary skill in the art, the implementation of all or part of the processes in the embodiments of the method described above may be completed by instructing related hardware through a computer program, and the program may be stored in a computer readable storage medium. When it is executed, the program may comprise the processes of the embodiments of the methods described above. The storage medium may be a magnetic disk, an optical disk, a Read-Only Memory (ROM) or a Random Access Memory (RAM) or the like.

Finally, it shall be noted that, the above embodiments are only used to illustrate the technical solutions of the present application, and are not intended to limit the present application. Under the idea of the present application, technical features in the above embodiments or different embodiments may also be combined, the steps may be implemented in any order, and many other variations in different aspects of the present application as described above are possible, and these variations are not provided in details for conciseness. Although the present application has been described in detail with reference to the foregoing embodiments, those of ordinary skill in the art shall appreciate that, the technical solutions described in the foregoing embodiments may still be modified or some of the technical features may be equivalently replaced within the scope of the present invention which is defined by the appended claims.

**Claims**

1. A method for estimating SOC of a lithium battery, comprising steps of:

collecting state data and corresponding SOC values of lithium batteries under different working conditions and establishing a sample set, and performing clustering analysis on the sample set to obtain a plurality of sample subsets;

establishing a corresponding sub-model for each of the sample subsets by performing linear regression operation to obtain sub-model functions of the plurality of sample subsets;

**characterized by**

adding the state data of a sample to be tested respectively into the state data of each of the sample subsets, calculating a change value of the state data of each of the sample subsets before and after the adding operation, and selecting at least one sub-model close to the sample to be tested as the selected sub-model according to the change value;

assigning a weight to the selected sub-model, and calculating the SOC value of the sample to be tested;

the step of assigning a weight to the selected sub-model comprises:

making the weight of each selected sub-model in the selected sub-models be $P(X_s|x_{test})$, , s=q1, q2, ..., qNc;

the expression formula of the weight is as follows:

$$P(X_s \mid x_{test}) = \frac{P(X_s)P(x_{test} \mid X_s)}{\sum_{s=q_1}^{q_{N_c}} P(X_s)P(x_{test} \mid X_s)}$$

wherein

$$P(x_{test} \mid X_s) = \frac{K_s^{'}}{\sum_{s=q_1}^{q_{N_c}} K_s^{'}}$$

$$P(X_s) = \frac{1}{N_c}.$$

wherein $P(X_s)$ is the prior probability that $X_s$ can describe the current working condition of the lithium battery, $P$

$(x_{test} \mid X_s)$ represents the probability that $x_{test}$ may be generated by $X_s$;
the step of calculating the SOC value of the sample to be tested is to calculate the SOC value through the following formula:

$$\hat{y}_{test} = \sum_{s=q_1}^{q_{N_c}} P(X_s \mid x_{test}) f_s(x_{test}) = \frac{\displaystyle\sum_{s=q_1}^{q_{N_c}} K'_s f_s(x_{test})}{\displaystyle\sum_{s=q_1}^{q_{N_c}} K'_s}$$

wherein $y_{test}$ is the estimated value of SOC, $x_{test}$ is the state data of a sample to be tested, $q_1$ is the selected 1st sub-model, $q_{N_c}$ is the selected $N_c$st $P(X_s \mid x_{test})$ sub-model, s is the selected sst sub-model, is the weight of the selected sst sub-model, $f_s(x_{test})$ is the sub-model function of the selected sst sub-model, $K'_s$ is the divergence information value.

2. The method according to Claim 1, being **characterized in that**, the state data of the lithium battery comprises at least one of charging and discharging current, terminal voltage and temperature of the lithium battery.

3. The method according to Claim 1, being **characterized in that**, the step of performing clustering analysis on the sample set to obtain a plurality of sample subsets comprises: performing clustering analysis on the sample set to obtain a plurality of sample subsets by using the K-means algorithm, which comprises steps of:

initializing the number N of sample subsets and the maximum iteration number $N_{inter}$;
randomly selecting the state data of N samples from the sample set as centers $\mu_1$, $\mu_2$,...,$\mu_j$,...,$\mu_N$ of N sample subsets $(X_1,Y_1)$, $(X_2,Y_2)$,....,$(X_j,Y_j)$,...,$(X_N,Y_N)$, wherein X represents the state data, Y represents the SOC value, and $\mu$ represents the cluster center, $1 \leq j \leq N$;
setting k = 1, 2,...,$N_{inter}$;
initializing each of the N sample subsets $(X_1,Y_1)$, $(X_2,Y_2)$,....,$(X_j,Y_j)$,...,$(X_N,Y_N)$ into an empty set $(X_j,Y_j)=\varphi$, j=1,2,...,N;
calculating the distance between the state data $x_i$ of each sample $(x_i,y_i)$ and each cluster center $\mu_j$, wherein $x_i$ represents the state data of a certain sample and $y_i$ represents the SOC value of a certain sample; and the formula for calculation is as follows:

$$d_{i,j} = \left\| x_i - \mu_j \right\|_2^2 ;$$

putting the sample $(x_i,y_i)$ into the sample subset $(X_j,Y_j)$ corresponding to the smallest $d_{i,j}$, and updating the sample subset $(X_j,Y_j) =(X_j,Y_j) \cup (x_i,y_i)$;

$$\mu_j = \frac{1}{\left| X_j \right|} \sum_{x \in X_j} x$$

calculating the cluster center of each updated sample subset, wherein $|X_j|$ is the number of samples of the jth sample subset;

$$\sum_{j=1}^{N} |\mu_j(k) - \mu_j(k-1)| \leq 0.01$$

if       , then outputting sample subsets $(X_1,Y_1)$, $(X_2,Y_2),...,(X_j,Y_j),..,(X_N,Y_N)$, wherein $k=1,2,...,N_{inter}$;

otherwise, making $k \leftarrow k + 1$ until the iteration number reaches the maximum iteration number $N_{inter}$.

**4.** The method according to Claim 1, being **characterized in that**, the step of establishing a corresponding sub-model for each of the sample subsets to obtain sub-model functions of the plurality of sample subsets comprises: establishing a corresponding PLS sub-model for each of the sample subsets by using a partial least squares regression method to obtain PLS sub-model functions of the plurality of sample subsets;

the PLS sub-model is expressed as follows:

$$\begin{cases} X_j = T_j P_j^T + E_{X_j} \\ Y_j = U_j Q_j^T + E_{Y_j} \end{cases}$$

wherein $T_j$ and $U_j$ are the score matrices of the jth PLS sub-model, $P_j$ and $Q_j$ are the load matrices of the jth PLS sub-model, and $E_{Xj}$ and $E_{Yj}$ are the residual matrices of the jth PLS sub-model;
the score matrices are linked by linear regression:

$$U_j = T_j B_j + E_j$$

wherein $B_j$ and $E_j$ are the diagonal matrix and regression residual matrix of the jth PLS sub-model respectively;
the PLS sub-model functions of the plurality of sample subsets are expressed as follows:

$$\begin{cases} f_1 = T_1 B_1 Q_1^T \\ \vdots \\ f_j = T_j B_j Q_j^T \\ \vdots \\ f_N = T_N B_N Q_N^T \end{cases}$$

wherein f represents the sub-model function.

**5.** The method according to Claim 1, being **characterized in that**, the operation of adding the state data of a sample to be tested respectively into the state data of each of the sample subsets and calculating a change value of the state data of each of the sample subsets before and after the adding operation comprises:

adding the state data $x_{test}$ of the sample to be tested respectively into the state data $x_1,...,x_j,..., x_N$ of each of the sample subsets to obtain new state data $(X_1, x_{test}),..., (X_j, x_{test}),..., (X_N, x_{test})$;
calculating a first divergence information value $K_j$ between $X_j$ and $(X_j, x_{test})$, wherein the formula of the first divergence information value $K_j$ is as follows:

$$K_j = K[X_j \parallel (X_j, x_{test})]$$

$$= \frac{1}{2} trace \left\{ (\Sigma_1 - \Sigma_2)(\Sigma_2^{-1} - \Sigma_1^{-1}) \right\} + \frac{1}{2} trace \left\{ (\Sigma_1^{-1} + \Sigma_2^{-1})(\sigma_1 - \sigma_2)(\sigma_1 - \sigma_2)^T \right\}$$

wherein $\Sigma_1$ and $\sigma_1$ are respectively the covariance matrix and mean of $X_j$, $\Sigma_2$ and $\sigma_2$ are respectively the covariance matrix and mean of $(X_j, x_{test})$, and trace is the matrix tracing operator;

performing normalization processing on the first divergence information value $K_j$ to obtain a second divergence information value $K_j^{'}$, wherein the formula for normalization is as follows:

$$K_j^{'} = 1 - \frac{K_j - \min(K_1, K_2, \cdots K_N)}{\max(K_1, K_2, \cdots K_N) - \min(K_1, K_2, \cdots K_N)} \in [0,1]$$

.

6. The method according to Claim 5, being **characterized in that**, the step of selecting at least one sub-model close to the sample to be tested as the selected sub-model according to the change value comprises:

   comparing $K_j^{'}$ with a preset divergence information value $\varepsilon$, and taking the sub-model which corresponds to $K_j^{'}$ not less than the preset divergence information value $\varepsilon$ as the selected sub-model close to the sample to be tested,

   and the expression formula of a set of the selected sub-models is as follows:

   $$Q_c = \left\{ q_1, q_2, \cdots, q_{N_c} \right\}, \quad Q_c = \left\{ j \mid K_j^{'} \ge \varepsilon \right\},$$

   wherein $N_c$ is the total number of the selected sub-models, $q_1, q_2, ..., q_{Nc}$ is the 1st, second, ..., Nc st sub-model.

7. A computer readable storage medium, being **characterized in that**, having computer executable instructions stored therein, the computer executable instructions causing a computer to execute the method according to any of Claims 1 to 6.

**Patentansprüche**

1. Verfahren zum Schätzen des Ladezustands, SOC, einer Lithiumbatterie, das die folgenden Schritte umfasst:

   Sammeln von Zustandsdaten und entsprechenden SOC-Werten von Lithiumbatterien unter verschiedenen Arbeitsbedingungen und Erstellen eines Probensatzes sowie Durchführen einer Cluster-Analyse des Probensatzes, um eine Vielzahl von Probenuntermengen zu erhalten;
   Erstellen eines entsprechenden Untermodells für jede der Probenuntermengen durch Durchführen eines linearen Regressionsvorgangs, um Untermodellfunktionen der Vielzahl von Probenuntermengen zu erhalten;
   **gekennzeichnet durch** das Hinzufügen der Zustandsdaten einer zu testenden Probe jeweils zu den Zustandsdaten jeder der Probenuntermengen, das Berechnen eines Änderungswerts der Zustandsdaten jeder der Probenuntermengen vor und nach dem Hinzufügen, und das Auswählen von mindestens einem Untermodell, das der zu testenden Probe nahe kommt, als das ausgewählte Untermodell entsprechend dem Änderungswert;
   Zuweisen einer Gewichtung zum ausgewählten Untermodell und Berechnen des SOC-Werts der zu testenden Probe;
   wobei der Schritt des Zuweisens einer Gewichtung zu dem ausgewählten Untermodell umfasst:

   Sicherstellen, dass die Gewichtung jedes ausgewählten Untermodells in den ausgewählten Untermodellen

$P(X_s|x_{Test})$, s=q$_1$, q$_2$, ..., q$_{Nc}$ entspricht;
wobei der Ausdruck der Gewichtung als Formel wie folgt lautet:

$$P(X_s|x_{Test}) = \frac{P(X_s)P(x_{Test}|X_s)}{\sum_{s=q_1}^{q_{Nc}} P(X_s)P(x_{Test}|X_s)}$$

worin

$$P(X_{Test}|X_s) = \frac{K_s'}{\sum_{s=q_1}^{q_{Nc}} K_s'}$$

$$P(X_s) = \frac{1}{N_c};$$

worin P(X$_s$) die vorherige Wahrscheinlichkeit ist, dass X$_s$ den aktuellen Betriebszustand der Lithiumbatterie beschreiben kann, $P(X_{Test}|X_s)$ die Wahrscheinlichkeit darstellt, dass x$_{Test}$ von X$_s$ generiert werden kann; wobei der Schritt zum Berechnen des SOC-Werts der zu testenden Probe darin besteht, den SOC-Wert mithilfe der folgenden Formel zu berechnen:

$$\hat{y}_{Test} = \sum_{s=q_1}^{q_{Nc}} P(X_s|X_{Test}) f_s(X_{Test}) = \frac{\sum_{s=q_1}^{q_{Nc}} K_s' f_s(X_{Test})}{\sum_{s=q_1}^{q_{Nc}} K_s'};$$

worin $\hat{y}_{Test}$ der geschätzte Wert des SOC ist, x$_{Test}$ die Zustandsdaten einer zu testenden Probe ist, q$_1$ das ausgewählte 1. Untermodell ist, q$_{Nc}$ das ausgewählte Nc-te Untermodell ist, s das ausgewählte s-te Untermodell ist, $P(X_s|x_{Test})$ die Gewichtung des ausgewählten s-ten Untermodells ist, f$_s$(x$_{Test}$) die Untermodell-funktion des ausgewählten s-ten Untermodells ist, $K_s'$ der Divergenzinformationswert ist.

2. Verfahren nach Anspruch 1, **dadurch gekennzeichnet, dass** die Zustandsdaten der Lithiumbatterie mindestens eines von Lade- und Entladestrom, Klemmenspannung und Temperatur der Lithiumbatterie umfassen.

3. Verfahren nach Anspruch 1, **dadurch gekennzeichnet, dass** der Schritt des Durchführens einer Cluster-Analyse an dem Probensatz, um eine Vielzahl von Probenuntermengen zu erhalten, umfasst: Durchführen einer Cluster-Analyse an dem Probensatz, um eine Vielzahl von Probenuntermengen unter Verwendung des K-Means-Algorithmus zu erhalten, der die folgenden Schritte umfasst:

Initialisieren der Anzahl N der Probenuntermengen und der maximalen Iterationszahl N$_{inter}$;
zufälliges Auswählen der Zustandsdaten von N Proben aus dem Probensatz als Zentren $\mu_1, \mu_2,...,\mu_j,...,\mu_N$ von N Probenuntermengen (X$_1$,Y$_1$), (X$_2$,Y$_2$),...,(X$_j$,Y$_j$),...,(X$_N$,Y$_N$), wobei X die Zustandsdaten darstellt, Y den SOC-Wert darstellt und $\mu$ das Cluster-Zentrum, $1 \le j \le N$, darstellt;
Einstellen von k = 1, 2,...,N$_{inter}$ ;
Initialisieren jeder der N Probenuntermengen (X$_1$,Y$_1$), (X$_2$,Y$_2$),...,(X$_j$,Y$_j$),...,(X$_N$,Y$_N$) in einen leeren Satz (X$_j$,Y$_j$)=$\varphi$, j=1,2,...,N;
Berechnen des Abstands zwischen den Zustandsdaten x$_i$ jeder Probe (x$_i$,y$_i$) und jedem Cluster-Zentrum $\mu_j$, wobei x$_i$ die Zustandsdaten einer bestimmten Probe darstellt und y$_i$ den SOC-Wert einer bestimmten Probe darstellt; und die Berechnungsformel wie folgt lautet:

$$d_{i,j} = \left\| x_i - \mu_j \right\|_2^2;$$

Einfügen der Probe (x$_i$,y$_i$) in die Probenuntermenge (X$_j$,Y$_j$), die dem kleinsten d$_{i,j}$ entspricht, und Aktualisieren der Probenuntermenge (X$_j$,Y$_j$) =(X$_j$,Y$_j$) $\cup$ (x$_i$,y$_i$);

Berechnen des Cluster-Zentrums $\mu_j = \frac{1}{|X_j|}\sum_{x \in X_j} x$ jeder aktualisierten Probenuntermenge, wobei $|X_j|$ die Anzahl an Proben der j-ten Probenuntermenge ist;

wenn $\sum_{j=1}^{N}|\mu_j(k) - \mu_j(k-1)| \leq 0,01$ , dann Ausgeben von Probenuntermengen $(X_1,Y_1)$, $(X_2,Y_2),...,(X_j,Y_j),...,(X_N,Y_N)$, wobei k=1,2,...,$N_{inter}$;

anderenfalls wird k←k + 1 ausgeführt, bis die Iterationszahl die maximale Iterationszahl $N_{inter}$ erreicht.

4. Verfahren nach Anspruch 1, **dadurch gekennzeichnet, dass** der Schritt des Erstellens eines entsprechenden Untermodells für jede der Probenuntermengen, um Untermodellfunktionen der Vielzahl von Probenuntermengen zu erhalten, umfasst: Erstellen eines entsprechenden PLS-Untermodells für jede der Probenuntermengen durch Verwenden einer Methode der partiellen kleinsten Quadrate-Regression, um PLS-Untermodellfunktionen der Vielzahl von Probenuntermengen zu erhalten;

wobei sich das PLS-Untermodell wie folgt ausdrückt:

$$\begin{cases} X_j = T_j P_j^T + E_{X_j} \\ Y_j = U_j Q_j^T + E_{Y_j} \end{cases}$$

worin $T_j$ und $U_j$ die Bewertungsmatrizen des j-ten PLS-Untermodells, $P_j$ und $Q_j$ die Belastungsmatrizen des j-ten PLS-Untermodells und $E_{Xj}$ und $E_{Yj}$ die Restmatrizen des j-ten PLS-Untermodells sind;
wobei die Bewertungsmatrizen durch lineare Regression verknüpft sind:

$$U_j = T_j B_j + E_j$$

wobei $B_j$ und $E_j$ die Diagonalmatrix bzw. die Regressionsrestmatrix des j-ten PLS-Untermodells sind;
wobei die PLS-Untermodellfunktionen der Vielzahl von Probenuntermengen sich wie folgt ausdrücken:

$$\begin{cases} f_1 = T_1 B_1 Q_1^T \\ \vdots \\ f_j = T_j B_j Q_j^T \\ \vdots \\ f_N = T_N B_N Q_N^T \end{cases}$$

wobei f die Untermodellfunktion darstellt.

5. Verfahren nach Anspruch 1, **dadurch gekennzeichnet, dass** der Vorgang des Hinzufügens der Zustandsdaten einer jeweils zu testenden Probe zu den Zustandsdaten jeder der Probenuntermengen und des Berechnens eines Änderungswerts der Zustandsdaten jeder der Probenuntermengen vor und nach dem Hinzufügen Folgendes umfasst:

Hinzufügen der Zustandsdaten $x_{Test}$ der jeweils zu testenden Probe zu den Zustandsdaten $x_1,...,x_j,..., x_N$ jeder der Probenuntermengen, um neue Zustandsdaten $(X_1, x_{Test}),..., (X_j, x_{Test}),..., (X_N, X_{Test})$ zu erhalten;
Berechnen eines ersten Divergenzinformationswerts $K_j$ zwischen $X_j$ und $(X_j, x_{Test})$, wobei die Formel des ersten Divergenzinformationswerts $K_j$ wie folgt lautet:

$$K_j = K[X_j \| (X_j, x_{Test})]$$
$$= \frac{1}{2} trace\left\{(\Sigma_1 - \Sigma_2)(\Sigma_2^{-1} - \Sigma_1^{-1})\right\} + \frac{1}{2} trace\left\{(\Sigma_1^{-1} + \Sigma_2^{-1})(\sigma_1 - \sigma_2)(\sigma_1 - \sigma_2)^T\right\}$$

worin $\Sigma_1$ und $\sigma_1$ jeweils die Kovarianzmatrix und der Mittelwert von $X_j$ sind, $\Sigma_2$ und $\sigma_2$ jeweils die Kovarianzmatrix und der Mittelwert von ($X_j$, $x_{Test}$) sind und "trace" der Matrix-Tracing-Operator ist;
Durchführen einer Normalisierungsverarbeitung an dem ersten Divergenzinformationswert $K_j$ zum Erhalten eines zweiten Divergenzinformationswerts $K_j'$, wobei die Formel zur Normalisierung wie folgt lautet:

$$K_j' = 1 - \frac{K_j - \min(K_1, K_2, \cdots K_N)}{\max(K_1, K_2, \cdots K_N) - \min(K_1, K_2, \cdots K_N)} \in [0,1]$$

6. Verfahren nach Anspruch 5, **dadurch gekennzeichnet, dass** der Schritt des Auswählens von mindestens einem Untermodell, das der zu testenden Probe nahe kommt, als das ausgewählte Untermodell gemäß dem Änderungswert umfasst:

Vergleichen $K_j'$ mit einem vorgegebenen Divergenzinformationswert $\varepsilon$ und unter Berücksichtigung des Untermodells, das $K_j'$ entspricht und nicht kleiner als der voreingestellte Divergenzinformationswert $\varepsilon$ ist, als das ausgewählte Untermodell, das der zu testenden Probe am nächsten kommt, und wobei der Ausdruck eines Satzes der ausgewählten Untermodelle der folgenden Formel entspricht:

$$Q_c = \left\{q_1, q_2, \cdots, q_{N_c}\right\} \quad Q_c = \left\{j \mid K_j' \geq \varepsilon\right\}$$

worin $N_c$ die Gesamtzahl der ausgewählten Untermodelle ist und $q_1$,$q_2$,...,$q_{Nc}$ das 1., zweite, ..., Nc-te Untermodell ist.

7. Computerlesbares Speichermedium, das
**dadurch gekennzeichnet ist, dass** es computerausführbare Anweisungen darauf gespeichert hat, wobei die computerausführbaren Anweisungen einen Computer veranlassen, das Verfahren nach einem der Ansprüche 1 bis 6 auszuführen.

**Revendications**

1. Procédé d'estimation de l'état de charge, SOC, d'une batterie au lithium, comprenant les étapes suivantes consistant à :

recueillir des données d'état et des valeurs SOC correspondantes de batteries au lithium dans différentes conditions de travail et établir un ensemble d'échantillons, et réaliser une analyse par regroupement sur l'ensemble d'échantillons pour obtenir une pluralité de sous-ensembles d'échantillons ;
établir un sous-modèle correspondant pour chacun des sous-ensembles d'échantillons en réalisant une opération de régression linéaire pour obtenir des fonctions de sous-modèle de la pluralité de sous-ensembles d'échantillons ;
**caractérisé par** le fait d'ajouter des données d'état d'un échantillon à tester respectivement dans les données d'état de chacun des sous-ensembles d'échantillons, calculer une valeur de changement des données d'état de chacun des sous-ensembles d'échantillons avant et après l'opération d'ajout, et sélectionner au moins un sous-modèle proche de l'échantillon à tester en tant que sous-modèle sélectionné selon la valeur de changement ;
attribuer une pondération au sous-modèle sélectionné et calculer la valeur SOC de l'échantillon à tester ;
l'étape consistant à attribuer une pondération au sous-modèle sélectionné comprend :

le fait de faire en sorte que la pondération de chaque sous-modèle sélectionné dans les sous-modèles sélectionnés soit $P(X_s|x_{test})$, s=$q_1$, $q_2$, ..., $q_{Nc}$ ;
la formule d'expression de la pondération est la suivante :

$$P(X_s \mid x_{test}) = \frac{P(X_s)P(x_{test} \mid X_s)}{\sum_{s=q_1}^{q_{N_c}} P(X_s)P(x_{test} \mid X_s)}$$

où

$$P(x_{test} \mid X_s) = \frac{K_s'}{\sum_{s=q_1}^{q_{N_c}} K_s'}$$

$$P(X_s) = \frac{1}{N_c} ;$$

où $P(X_s)$ est la probabilité préalable que $X_s$ puisse décrire l'état de fonctionnement actuel de la batterie au lithium, $P(x_{test} \mid X_s)$ représente la probabilité que $x_{test}$ puisse être généré par $X_s$ ;
l'étape de calcul de la valeur SOC de l'échantillon à tester consiste à calculer la valeur SOC par le biais de la formule suivante :

$$\hat{y}_{test} = \sum_{s=q_1}^{q_{N_c}} P(X_s \mid x_{test})f_s(x_{test}) = \frac{\sum_{s=q_1}^{q_{N_c}} K_s' f_s(x_{test})}{\sum_{s=q_1}^{q_{N_c}} K_s'} ;$$

où $\hat{y}_{test}$ est la valeur estimée de SOC, $x_{test}$ correspond aux données d'état d'un échantillon à tester, $q_1$ est le 1er sous-modèle sélectionné, $q_{Nc}$ est le NC$^{ième}$ sous-modèle sélectionné, s est le s$^{ième}$ sous-modèle sélectionné, $P(X_s|x_{test})$ est la pondération du s$^{ième}$ sous-modèle sélectionné, $f_s(x_{test})$ est la fonction de sous-modèle du s$^{ième}$ sous-modèle sélectionné, $K_s'$ est la valeur d'informations de divergence.

**2.** Procédé selon la revendication 1, étant **caractérisé en ce que** les données d'état de la batterie au lithium comprennent au moins l'un parmi un courant de charge et de décharge, une tension de borne et une température de la batterie au lithium.

**3.** Procédé selon la revendication 1, étant **caractérisé en ce que** l'étape consistant à réaliser une analyse par regroupement sur l'ensemble d'échantillons pour obtenir une pluralité de sous-ensembles d'échantillons comprend : la réalisation d'une analyse par regroupement sur l'ensemble d'échantillons pour obtenir une pluralité de sous-ensembles d'échantillons à l'aide de l'algorithme à K moyennes, qui comprend les étapes suivantes consistant à :

initialiser le nombre N de sous-ensembles d'échantillons et le nombre maximal d'itérations $N_{inter}$ ;
sélectionner de manière aléatoire les données d'état de N échantillons de l'ensemble d'échantillons en tant que centres $\mu_1$, $\mu_2$,...,$\mu_j$,...,$\mu_N$ de N sous-ensembles d'échantillons $(X_1,Y_1)$, $(X_2,Y_2)$,...,$(X_j,Y_j)$,...,$(X_N,Y_N)$, où X représente les données d'état, Y représente la valeur SOC et $\mu$ représente le centre du groupe, $1 \le j \le N$ ;
définir k = 1,2,...,$N_{inter}$ ;
initialiser chacun des N sous-ensembles d'échantillons $(X_1,Y_1)$, $(X_2,Y_2)$,...,$(X_j,Y_j)$,...,$(X_N,Y_N)$ en un ensemble vide $(X_j,Y_j)=\varphi$, j=1,2,...,N ;
calculer la distance entre les données d'état $x_i$ de chaque échantillon $(x_i,y_i)$ et de chaque centre de groupe $\mu_j$, où $x_i$ représente les données d'état d'un certain échantillon et $y_i$ représente la valeur SOC d'un certain échantillon ; et la formule de calcul est la suivante :

$$d_{i,j} = \left\| x_i - \mu_j \right\|_2^2 \quad ;$$

placer l'échantillon $(x_i, y_i)$ dans le sous-ensemble d'échantillons $(X_j, Y_j)$ correspondant au plus petit $d_{i,j}$, et mettre à jour le sous-ensemble d'échantillons $(X_j, Y_j) = (X_j, Y_j) \cup (x_i,y_i)$ ;

$$\mu_j = \frac{1}{|X_j|} \sum_{x \in X_j} x$$

calculer le centre de groupe de chaque sousensemble d'échantillons mis à jour, où $|X_j|$ est le nombre d'échantillons du j-ième sous-ensemble d'échantillons ;

$$\sum_{j=1}^{N} | \mu_j(k) - \mu_j(k-1) | \le 0.01$$

si , alors produire des sous-ensembles d'échantillons $(X_1,Y_1)$, $(X_2,Y_2)$,...,$(X_j,Y_j)$,...,$(X_N,Y_N)$, où k=1,2,...,$N_{inter}$ ;
sinon, faire en sorte que k←k + 1 jusqu'à ce que le nombre d'itérations atteigne le nombre d'itérations maximum $N_{inter}$.

**4.** Procédé selon la revendication 1, **caractérisé en ce que** l'étape consistant à établir un sous-modèle correspondant pour chacun des sous-ensembles d'échantillons afin d'obtenir des fonctions de sous-modèle de la pluralité de sous-ensembles d'échantillons comprend : l'établissement d'un sous-modèle PLS correspondant pour chacun des sous-ensembles d'échantillons à l'aide d'une méthode de régression des moindres carrés partielle afin d'obtenir des fonctions de sous-modèle PLS de la pluralité de sous-ensembles d'échantillons ;

le sous-modèle PLS est exprimé comme suit :

$$\begin{cases} X_j = T_j P_j^T + E_{X_j} \\ Y_j = U_j Q_j^T + E_{Y_j} \end{cases}$$

où $T_j$ et $U_j$ sont les matrices de score du j-ième sous-modèle PLS, $P_j$ et $Q_j$ sont les matrices de charge du j-ième sous-modèle PLS, et $E_{Xj}$ et $E_{Yj}$ sont les matrices résiduelles du j-ième sous-modèle PLS ;
les matrices de score sont liées par régression linéaire :

$$U_j = T_j B_j + E_j$$

où $B_j$ et $E_j$ sont respectivement la matrice diagonale et la matrice résiduelle de régression du j-ième sous-modèle PLS ;
les fonctions de sous-modèle PLS de la pluralité de sous-ensembles d'échantillons sont exprimées comme suit :

$$\begin{cases} f_1 = T_1 B_1 Q_1^T \\ \vdots \\ f_j = T_j B_j Q_j^T \\ \vdots \\ f_N = T_N B_N Q_N^T \end{cases}$$

où f représente la fonction de sous-modèle.

5. Procédé selon la revendication 1, **caractérisé en ce que** l'opération consistant à ajouter les données d'état d'un échantillon à tester respectivement aux données d'état de chacun des sous-ensembles d'échantillons et à calculer une valeur de changement des données d'état de chacun des sous-ensembles d'échantillons avant et après l'opération d'ajout comprend :

l'ajout des données d'état $x_{test}$ de l'échantillon à tester respectivement aux données d'état $x_1,...,x_j,..., x_N$ de chacun des sous-ensembles d'échantillons pour obtenir de nouvelles données d'état $(X_1, x_{test}),..., (X_j, x_{test}),..., (X_N, x_{test})$ ;
le calcul d'une première valeur d'informations de divergence $K_j$ entre $X_j$ et $(X_j, x_{test})$, dans lequel la formule de la première valeur d'informations de divergence $K_j$ est la suivante :

$$K_j = K[X_j \parallel (X_j, x_{test})]$$
$$= \frac{1}{2} trace\left\{(\Sigma_1 - \Sigma_2)(\Sigma_2^{-1} - \Sigma_1^{-1})\right\} + \frac{1}{2} trace\left\{(\Sigma_1^{-1} + \Sigma_2^{-1})(\sigma_1 - \sigma_2)(\sigma_1 - \sigma_2)^T\right\}$$

où $\Sigma_1$ et $\sigma_1$ sont respectivement la matrice de covariance et la moyenne de $X_j$, $\Sigma_2$ et $\sigma_2$ sont respectivement la matrice de covariance et la moyenne de $(X_j, x_{test})$, et trace est l'opérateur de traçage matriciel ;
la réalisation d'un traitement de normalisation sur la première valeur d'informations de divergence $K_j$ pour obtenir une seconde valeur d'informations de divergence $K_j^{'}$ , dans lequel la formule de normalisation est la suivante :

$$K_j' = 1 - \frac{K_j - \min(K_1, K_2, \cdots K_N)}{\max(K_1, K_2, \cdots K_N) - \min(K_1, K_2, \cdots K_N)} \in [0,1]$$

6. Procédé selon la revendication 5, étant **caractérisé en ce que** l'étape consistant à sélectionner au moins un sous-modèle proche de l'échantillon à tester en tant que sous-modèle sélectionné selon la valeur de changement comprend :

la comparaison $K_j'$ à une valeur d'informations de divergence prédéfinie ε, et le fait de prendre le sous-modèle qui correspond à $K_j'$ au moins égale à la valeur d'informations de divergence prédéfinie ε en tant que sous-modèle sélectionné proche de l'échantillon à tester, et la formule d'expression d'un ensemble de sous-modèles sélectionnés est la suivante :

$$Q_c = \left\{ q_1, q_2, \cdots, q_{N_c} \right\} \quad Q_c = \left\{ j \mid K_j' \geq \varepsilon \right\}$$

où $N_c$ est le nombre total de sous-modèles sélectionnés, $q_1, q_2, ..., q_{Nc}$ est le 1er, deuxième, ..., Ncième sous-modèle.

7. Support de stockage lisible par ordinateur, étant **caractérisé en ce qu'il** contient des instructions exécutables par ordinateur, les instructions exécutables par ordinateur conduisant un ordinateur à exécuter le procédé selon l'une quelconque des revendications 1 à 6.

Collect state data and corresponding SOC values of lithium batteries under different working conditions and establishing a sample set, and performing clustering analysis on the sample set to obtain a plurality of sample subsets — S1

Establish a corresponding sub-model for each of the sample subsets to obtain sub-model functions of the plurality of sample subsets — S2

Add the state data of a sample to be tested respectively into the state data of each of the sample subsets, calculating a change value of the state data of each of the sample subsets before and after the adding operation, and selecting at least one sub-model close to the sample to be tested as the selected sub-model according to the change value — S3

Assign a weight to the selected sub-model, and calculating the SOC value of the sample to be tested — S4

FIG. 1

FIG. 2

Device for estimating
SOC of lithium battery
1

Acquisition module
11

Model establishing
module 12

Selection module 13

SOC calculating
module 14

FIG. 3

Electronic equipment 30

Processor 31

Memory 32

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111215850X
- CN 111693868 A
- CN 107367693 B

- US 2015362559 A1
- US 9244129 B2
- CN 107741568 A